(19) Europäisches Patentamt
European Patent Office
Office européen des brevets

(11) **EP 4 759 609 A1**

(12) **EUROPEAN PATENT APPLICATION**

(43) Date of publication:
**17.06.2026 Bulletin 2026/25**

(21) Application number: **24220199.4**

(22) Date of filing: **16.12.2024**

(51) International Patent Classification (IPC):
***B60L 3/00*** (2019.01)          ***B60L 58/26*** (2019.01)
***B60L 3/04*** (2006.01)

(52) Cooperative Patent Classification (CPC):
**B60L 58/26; B60L 3/0046; B60L 3/0069**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Volvo Truck Corporation
405 08 Göteborg (SE)**

(72) Inventors:
• **NEILSON, Rohan
  VÄSTERÅS (SE)**
• **BARKAH, Dani
  ESKILSTUNA (SE)**

(74) Representative: **Ström & Gulliksson AB
P.O. Box 4188
203 13 Malmö (SE)**

(54) **COMPUTER SYSTEM AND COMPUTER-IMPLEMENTED METHOD FOR DETECTING CHANGES IN ISOLATION RESISTANCE IN A FLUID PATH OF A COOLING SYSTEM**

(57)    Computer system comprising processing circuitry configured to obtain first isolation resistance data associated with an isolation resistance between poles of a vehicle subsystem of a vehicle and a ground connection wherein a fluid path of a cooling system configured to cool the vehicle subsystem is in a first state, obtain second isolation resistance data associated with an isolation resistance between the poles and the ground connection wherein the fluid path is in a second state, where the coolant in the fluid path is electrically energized at least in the second state and determine a change in isolation resistance.

FIG. 2A

FIG. 2B

**Description**

**TECHNICAL FIELD**

The disclosure relates generally to computer systems and computer-implemented methods. In particular aspects, the disclosure relates to a computer system and a computer-implemented method for detecting changes in isolation resistance in a fluid path of a cooling system, e.g. a cooling system of a vehicle. The disclosure can be applied to heavy-duty vehicles, such as trucks, buses, and construction equipment, among other vehicle types. Although the disclosure may be described with respect to a particular vehicle, the disclosure is not restricted to any particular vehicle.

**BACKGROUND**

In vehicles and in particular electric vehicles, managing thermal and electrical safety is increasingly important. Improving the integrity of cooling systems for components like traction batteries and electric motors may be of great importance, as there is a risk of the coolant carrying electrical currents, which could be hazardous.

Existing solutions often involve costly conductivity sensors that may not be reliable due to contamination. Additionally, traditional isolation resistance monitoring systems might not effectively assess components that are usually isolated, leading to undetected voltage leaks into the cooling system.

Current technologies frequently focus on measuring coolant conductivity but may not address grounding issues or detect voltage leaks comprehensively. These limitations suggest a need for more efficient and cost-effective monitoring approaches that can better utilize existing systems to improve safety and performance in vehicle operations.

**SUMMARY**

According to a first aspect of the disclosure a computer system is provided. The computer system comprises processing circuitry configured to: obtain first isolation resistance data associated with an isolation resistance between poles of a vehicle subsystem of a vehicle and a ground connection wherein a fluid path of a cooling system configured to cool the vehicle subsystem is in a first state, obtain second isolation resistance data associated with an isolation resistance between the poles and the ground connection wherein the fluid path is in a second state, wherein coolant in the fluid path is electrically energized at least in the second state, and determine a change in isolation resistance between the poles and the ground connection based on the first and second isolation resistance data, and generate control data for the vehicle based on the determined change. The first aspect of the disclosure may seek to detect potential faults in in a vehicle subsystem. A technical benefit may include providing a less complex and more cost efficient manner of monitoring coolant conductivity and system integrity efficiently.

Optionally in some examples, including in at least one preferred example, the processing circuitry may be further configured to obtain fluid path resistance data associated with the electrical resistance of the fluid path, and generate control data for the vehicle based on the determined change in isolation resistance and the fluid path resistance data. A technical benefit may include detecting such coolant conductivity and potential leaks in a simple, robust and cost effective manner.

Optionally in some examples, including in at least one preferred example, the processing circuitry may be further configured to responsive to the determined change in isolation resistance being outside a fluid path isolation resistance threshold, determine at least one of that the fluid path leaks into the vehicle subsystem and that contamination has occurred in the vehicle subsystem. A technical benefit may include early detection of leaks or contaminations to prevent damage to vehicle components.

Optionally in some examples, including in at least one preferred example, the processing circuitry may be further configured to responsive to the determined change in isolation resistance being outside a fault resistance threshold determine that a fault is present in at least one of the vehicle subsystem and the vehicle cooling system, A technical benefit may include identifying and addressing a fault in the vehicle cooling system or vehicle subsystem to improve safety.

Optionally in some examples, including in at least one preferred example, the processing circuitry may be further configured to responsive to the determined change in isolation resistance being outside a ground connection isolation resistance threshold, determine a faulty cooling system ground connection of the cooling system. A technical benefit may include identifying and addressing faulty connections to improve safety.

Optionally in some examples, including in at least one preferred example, the processing circuitry may be further configured to obtain the fluid path resistance data based on geometrical characteristics of the fluid path and/or characteristics of the coolant. A technical benefit may include providing more precise diagnostics based on specific system characteristics.

Optionally in some examples, including in at least one preferred example, the processing circuitry may be further configured to obtain a diagnostic or fault tracing command, and responsive to the diagnostic or fault tracing command cause a switch between the first and second state. A technical benefit may include enabling targeted diagnostics and maintenance interventions.

Optionally in some examples, including in at least one preferred example, the processing circuitry may be further configured to cause a change between the first and the second state via a probe exposed to the coolant. A technical benefit may include allowing for isolation resistance monitoring in a simple and cost effective manner.

Optionally in some examples, including in at least one preferred example, the processing circuitry may be further configured to energize the coolant in the fluid path via the probe exposed to the coolant to cause a change in energization between the first state and the second state. A technical benefit may include allowing for isolation resistance monitoring in a simple and cost effective manner.

Optionally in some examples, including in at least one preferred example, the processing circuitry may be further configured to control a flow adjusting device arranged in the fluid path to cause a change in the geometric characteristics of the coolant path between the first state and the second state. A technical benefit may include allowing for isolation resistance monitoring in a simple and cost effective manner.

According to a second aspect of the disclosure, a vehicle is provided. The vehicle comprises the computer system of any of examples described herein. The second aspect of the disclosure may seek to solve the problem of integrating a system that detects and responds to changes in isolation resistance within the vehicle's cooling and electrical systems. A technical benefit may include enabling vehicles to automatically adjust and respond to changes in system integrity, improving safety and reliability.

Optionally in some examples, including in at least one preferred example, the vehicle may further comprise an isolation monitoring device operatively connected to the processing circuitry and configured to measure the isolation between the poles and the ground connection to provide the first and second isolation resistance data. A technical benefit may include enhancing the accuracy of isolation resistance measurements, thereby allowing for more reliable system diagnostics.

Optionally in some examples, including in at least one preferred example, the vehicle may further comprise a switch selectively connecting a probe to a potential of the vehicle subsystem, such as the poles, wherein the processing circuitry is operatively connected to the switch to control said switch to selectively energize the probe to thereby energize the coolant. A technical benefit may be to bypass insulation allowing fluid that is not normally energized to be assessed.

Optionally in some examples, including in at least one preferred example, the vehicle may further comprise a set resistance arranged between the probe and a power source for energizing the probe. A technical benefit may include promoting safe current levels during probe energization, thereby enhancing the safety of the vehicle's electrical systems.

Optionally in some examples, including in at least one preferred example, the vehicle may further comprise at least one fuel cell system forming the vehicle subsystem. A technical benefit may include allowing for identifying potential issues relating to isolation resistance in a fuel cell system.

Optionally in some examples, including in at least one preferred example, the vehicle may further comprise at least one battery system forming the vehicle subsystem. A technical benefit may include allowing for identifying potential issues relating to isolation resistance in a battery system.

Optionally in some examples, including in at least one preferred example, the battery system may comprise one or more immersion cooled batteries and the cooling system is provided as an immersion cooling system. A technical benefit may include allowing for identifying potential issues relating to isolation resistance in an immersion cooled battery system.

Optionally in some examples, including in at least one preferred example, the vehicle may further comprise a shielding, conductor or collector plate, wherein said shielding, conductor or collector plate forms the probe and is arranged adjacent to an area of similar voltage potential of the one or more immersion cooled batteries. A technical benefit may include to enable utilization of commonly occurring components of an immersion cooled battery system for the generation of the control data based on the change in isolation resistance allowing for a less complex and more cost efficient computer system and vehicle subsystem.

Optionally in some examples, including in at least one preferred example, the vehicle may further comprise at least one motor drive system forming the vehicle subsystem. A technical benefit may include allowing for identifying potential issues relating to isolation resistance in a motor drive system. Another technical benefit may include specifically identifying fluid ingress, e.g. water ingress, or direct cooling fluid degradation prior to winding insulation failure.

Optionally in some examples, including in at least one preferred example, the vehicle may further comprise at least one battery system and/or fuel cell system forming the vehicle subsystem, wherein the processing circuitry is further configured to: energizing the coolant in the fluid path via a probe exposed to the coolant to cause a change in energization between the first state and the second state, obtain fluid path resistance data associated with the electrical resistance of the fluid path, generate control data for the vehicle based on the determined change in isolation resistance and the fluid path resistance data, and responsive to the determined change in isolation resistance being outside a fluid path isolation resistance threshold, determine at least one of that the fluid path leaks into the vehicle subsystem and that contamination has occurred in the vehicle subsystem. A technical benefit may include providing comprehensive monitoring and control of vehicle subsystems, which enhances operational safety and system reliability.

According to a third aspect of the disclosure, a computer-implemented method is provided. The computer-implemented method comprises obtaining, by processing circuitry of a computer system, first isolation resistance data associated with an isolation resistance between poles of a vehicle subsystem of a vehicle and a ground connection wherein a fluid path of a cooling system configured to cool the vehicle subsystem is in a first state, obtaining, by the processing circuitry, second isolation resistance data associated with an isolation resistance between the poles and the ground connection wherein the fluid path is in a second state, wherein coolant in the fluid path is electrically energized in at least the second state, determining, by the processing circuitry, a change in isolation resistance between the poles and the ground connection based on the first and second isolation resistance data, and generating, by the processing circuitry, control data for the vehicle based on the determined change. The third aspect of the disclosure may seek to detect potential faults in a vehicle subsystem. A technical benefit may include providing a less complex and more cost efficient manner of monitoring coolant conductivity and system integrity efficiently.

Optionally in some examples, including in at least one preferred example, the method may further comprise obtaining, by the processing circuitry, fluid path resistance data associated with the electrical resistance of the fluid path, and generating, by the processing circuitry, control data for the vehicle based on the determined change in isolation resistance and the fluid path resistance data. A technical benefit may include enhancing the precision of control data generation by incorporating fluid path resistance measurements.

Optionally in some examples, including in at least one preferred example, the method may further comprise responsive to the determined change in isolation resistance being outside a coolant isolation resistance threshold, determine, by the processing circuitry, at least one of that the fluid path leaks into the vehicle subsystem and that contamination has occurred in the vehicle subsystem. A technical benefit may include providing early detection capabilities for leaks or contaminations, thereby potentially preventing potential damage and improving the safety of the vehicle subsystem.

According to a fourth aspect of the disclosure, a computer program product is provided. The computer program product comprises program code for performing, when executed by the processing circuitry, the method of any of the examples described herein. The fourth aspect of the disclosure may seek to enable new vehicles and/or legacy vehicles to be conveniently configured, by software installation/update, to monitor and manage isolation resistance changes in vehicle systems. A technical benefit may include offering a softwarebased solution that enhances system monitoring capabilities without significant hardware changes.

According to a fifth aspect of the disclosure, a non-transitory computer-readable storage medium is provided. The non-transitory computer-readable storage medium comprises instructions, which when executed by the processing circuitry, cause the processing circuitry to perform the method of any of the examples described herein. The fifth aspect of the disclosure may seek to enable new vehicles and/or legacy vehicles to be conveniently configured, by software installation/update, to enhance system safety and reliability through improved monitoring technologies. A technical benefit may include providing a flexible and scalable approach to implement system monitoring and control solutions.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

FIG. 1 is an exemplary side view of a vehicle according to an example.

FIG. 2A is an exemplary system diagram of a vehicle subsystem and computer system according to an example.

FIG. 2B is an exemplary system diagram of a vehicle subsystem and computer system according to an example.

FIG. 3 is an exemplary vehicle subsystem and cooling system according to an example.

FIG. 4 is an exemplary vehicle subsystem and cooling system according to an example.

FIG. 5 is an exemplary vehicle subsystem and cooling system according to an example.

FIG. 6 is an exemplary vehicle subsystem and cooling system according to an example.

FIG. 7 is a flow chart of an exemplary method according to an example.

FIG. 8 is a schematic diagram of an exemplary computer system for implementing examples disclosed herein, according to an example.

## DETAILED DESCRIPTION

The detailed description set forth below provides information and examples of the disclosed technology with sufficient detail to enable those skilled in the art to practice the disclosure.

In the following various examples will be given all related to the general idea of comparing an isolation resistance associated with a first state of a fluid path of a cooling system and an isolation resistance associated with a second state of the same fluid path. By comparing these isolation resistance data, it is possible to cause actions based on the findings. For example, an effective coolant conductivity of the fluid path may be determined, it may be determined whether the cooling system is grounded or whether voltage is leaking into the cooling system.

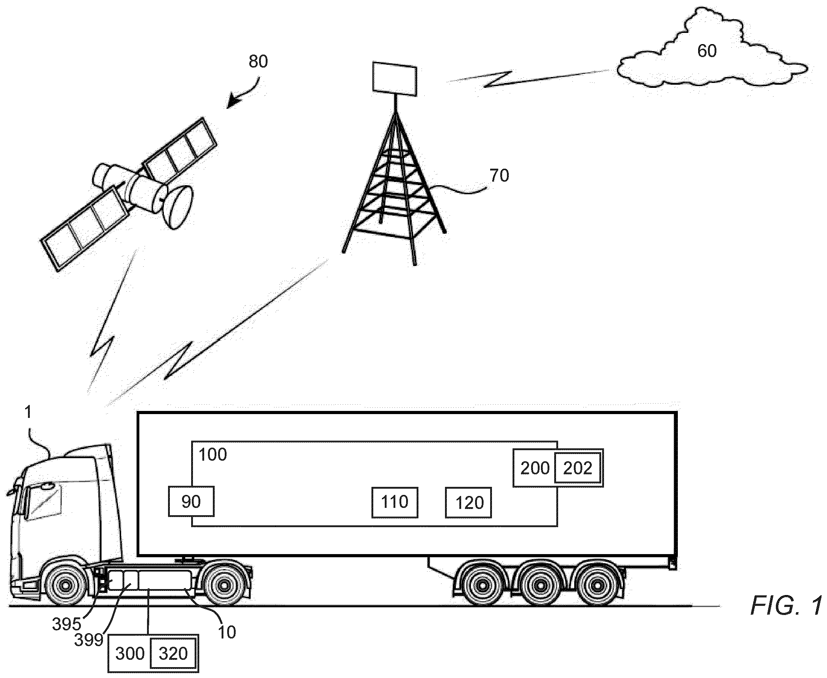

**FIG. 1** is an exemplary view of a vehicle **1** according to one example. The vehicle **1** comprises at least one isolation resistance monitoring system **200**. The at least one isolation resistance monitoring system **200** is configured to determine changes in the isolation resistance of a vehicle subsystem **10**. In particular, the isolation resistance monitoring system **200** is configured to determine such changes associated with changes in the state, e.g. operation, of a fluid path **320** of a cooling system **300** of the vehicle **1**. The cooling system 300 is configured to cool the vehicle subsystem **10**.

For example, the fluid path **320** may form a part of the vehicle subsystem **10**. The fluid path **320** may extend between the vehicle subsystem **10** and a pump **395** and/or a radiator **399**. The vehicle **1** is programmed to control the isolation resistance monitoring system **200**, as will be described further in the following.

As will be explained in further detail later on, the vehicle subsystem **10** may for example be formed by at least one fuel cell system, at least one battery system or at least one motor drive system of the vehicle **1**.

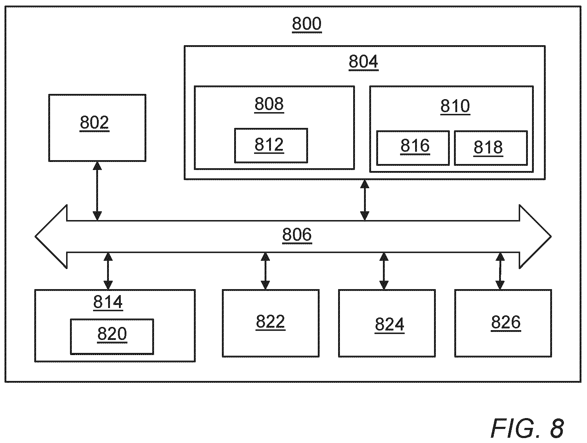

The vehicle **1** comprises, at least to some extent, processing circuitry **110** forming part of a computer system **100** (see **FIG. 8**). The processing circuitry **110** is configured to implement the isolation resistance monitoring system **200**.

The vehicle **1** may further comprise communications circuitry **90** configured to receive and/or send communications. The communications circuitry **90** may be configured to enable the vehicle **1** to communicate with one or more external devices or systems such as a cloud server **60**. The communication with the external devices or systems may be directly or via a communications interface such as a cellular communications interface **70**, such as a radio base station. The cloud server **60** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **90** may, additionally or alternatively, be configured to enable the vehicle **1** to be operatively connected to a Global Navigation Satellite System (GNSS) **80** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **1** may for example be configured to utilize data obtain from the GNSS **80** to determine a geographical location of the vehicle **1**.

The vehicle **1** in **FIG. 1** comprises the computer system **100** and the isolation resistance monitoring system **200**. The computer system **100** may be operatively connected to the isolation resistance monitoring system **200** and optionally to the communications circuitry **90** of the vehicle **1**. The computer system **100** comprises processing circuitry **110**. The computer system **100** may comprise a storage device **120,** advantageously a non-volatile storage device such as a hard disk drives (HDDs), solid-state drives (SSDs) etc. In some examples, the storage device **120** is operatively connected to the computer system **100**. The isolation resistance monitoring system **200** may comprise isolation resistance monitoring system processing circuitry **202**; the isolation resistance monitoring system processing circuitry **202** may be part of the processing circuitry **110** of the computer system **100**.

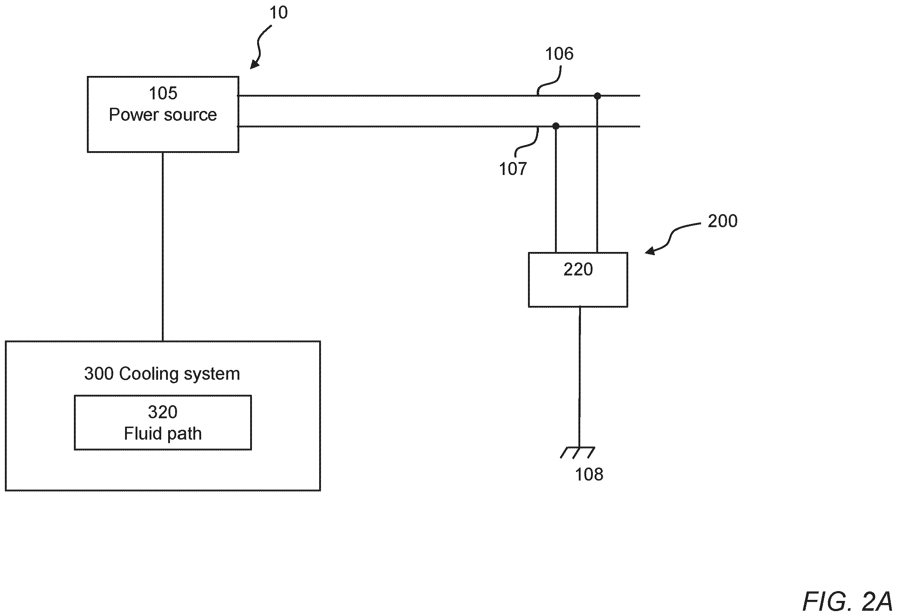

An example of a vehicle subsystem **10** is shown in **FIG. 2A.** The vehicle subsystem **10** is configured to be monitored by an isolation resistance monitoring system **200,** which in the shown example is at least partly embodied by an isolation resistance monitoring device **220**.

The processing circuitry **110**, in **FIG. 2A** embodied by the isolation resistance monitoring system **200** and in particular the isolation resistance monitoring device **220,** is configured obtain isolation resistance data. The isolation resistance data is associated with an isolation resistance between poles **106, 107** of the vehicle subsystem **10,** e.g. a power source **105** of the vehicle subsystem **10,** and a ground connection **108**.

The processing circuitry **110**, in **FIG. 2A** embodied by the isolation resistance monitoring system **200** and in particular the isolation resistance monitoring device **220,** is configured to obtain first isolation resistance data associated with the isolation resistance between the poles **106, 107** and the ground connection **108** where the fluid path **320** operates in a first state. Correspondingly, the processing circuitry **110**, in **FIG. 2A** embodied by the isolation resistance monitoring system **200** and in particular the isolation resistance monitoring device **220,** is configured to obtain second isolation resistance data associated with the isolation resistance between the poles **106, 107** and the ground connection **108** where the fluid path **320** operates in a second state.

At least in the second state, coolant in the fluid path **320** is electrically energized. Accordingly, the coolant may be subjected to an electric current.

The processing circuitry **110**, in **FIG. 2A** embodied by the isolation resistance monitoring system **200** and in particular the isolation resistance monitoring device **220,** is further configured to determine a change in isolation resistance between the poles **106, 107** and the ground connection **108** based on the first and second isolation resistance data and generate control data for the vehicle **1** based on the determined change.

The change in isolation resistance in view of the preset first and second state may be indicative of leakage of the fluid path **320** into the vehicle subsystem **10** or a fault in the vehicle subsystem **10** or the cooling system **300,** for example a faulty ground connections for the components of the cooling system **300.** The change in isolation resistance may be indicative of contamination, e.g. contamination by a conductive medium, of the vehicle subsystem **10.**

In some examples, the coolant in the fluid path **320** may be energized in both the first and the second state. According to such examples, the fluid path **320** may be energized to a different degree in the first respectively second state. Alternatively, the fluid path **320** may be energized to the same or different degrees in the first and second state and also be subjected to changes being associated with a change in the isolation resistance data. For example, the geometric characteristics and/or properties of the coolant in the fluid path **320** may be changed between the first state and the second state. In some examples, the coolant is only energized in the second state.

Notably, the coolant in the fluid path **320** being energized may herein refer to only a portion of the coolant in the fluid path **320** being energized or all of the coolant in the fluid path being energized. It may for example be envisioned that only the coolant in present in a delimited section of the fluid path **320** is energized.

The isolation resistance monitoring system **200** may be provided within the vehicle subsystem **10.** The isolation resistance monitoring system **200** may be configured to assess the isolation resistance between poles **106, 107** of the vehicle subsystem **10** and a ground connection **108.** This system could potentially be embodied by the isolation resistance monitoring device **220,** forming a part of a comprehensive monitoring setup. The function of this system may be to identify unintended electrical paths that could lead to faults or pose safety risks.

The processing circuitry **110,** which in some examples may integrate the isolation resistance monitoring system **200,** may be configured to obtain isolation resistance data. This data acquisition could occur under different operational states of a fluid path **320,** utilized in the cooling system **300** of the vehicle subsystem **10.** The data might be categorized as first and second isolation resistance data, corresponding to the different states of the fluid path **320,** potentially indicating changes in coolant conditions or system integrity.

The vehicle subsystem **10** may include various power sources **105,** such as a battery cell system, a fuel cell stack, or other energy storage solutions commonly used in vehicles and in particular electric vehicles.

Upon determining a change in isolation resistance, the processing circuitry **110** may generate control data for the vehicle **1.** This control data could be employed to adjust vehicle operations, thereby maintaining safety and performance. For instance, significant changes in isolation resistance could trigger alerts, adjust cooling system parameters, or alter power distribution among subsystems to mitigate potential damage or safety risks.

In **FIG. 2A,** the isolation resistance monitoring device **220** may be configured to measure the resistance to leakage between the poles **106, 107** and the ground connection **108** through a multitude of leakage paths which may be combined into a pair of combined total isolation resistances.

To exemplify, where no connection between the cooling system **300,** e.g. the fluid path **320,** and the ground connection **108** exists, whether the cooling system **300,** e.g. the fluid path **320,** is energized and to what level may be viewed as the product of the connections to the power source **105** and to the ground connection **108.**

In some cases there may be no connection between the cooling system **300,** e.g. the fluid path **320,** and the ground connection **108** (the resistance may be near infinite /negligibly high) and whereby the connection may be created by switching between the first and the second state to create a change (such that potential leakage through cooling system becomes real and detectable).

In other cases, the cooling system **300,** e.g. the fluid path **320,** (or parts thereof) may not be connected to the power source **105** but may connect to the ground connection **108.** In such cases, the cooling system **300,** e.g. the fluid path **320,** may be connected to the power source **105** thereby providing for turning a potential leak path into a real and measurable one.

In other cases this may be performed by shorting resistances.

Overall, this system may provide a monitoring approach that enhances a vehicle's capability to maintain operational safety and efficiency by proactively detecting irregularities by monitoring changes in the isolation resistance of the vehicle subsystem caused by induced changes in the cooling system, e.g. a fluid path of the cooling system.

For example, if a large drop in isolation resistance may occur when leakage current is allowed to flow through a coolant intended to cool a fuel cell system, this may indicate a high coolant conductivity. The processing circuitry may thus be configured to generate control data for shutting down the fuel cell system to prevent electrolysis of the coolant (even if the isolation resistance is still tolerable).

If the isolation resistance drops significantly when a leakage path is created through for example the coolant intended to cool a battery system such as an immersion cooled battery system, the processing circuitry may be configured to generate control data for shutting down one or more of batteries of the battery system. In some cases, all connected batteries may need to be shut-down.

If the isolation resistance drops significantly when a leakage path is created through an air gap in a vehicle subsystem in the form of a dry motor or through the fluid in a vehicle subsystem in the form of a direct liquid cooled motor, this may indicate water ingress or mechanical failure (e.g. Metal dust etc.). This may go undetected because the winding insulation/encapsulation prevents leakage but water and debris are common causes of winding faults, therefore detecting these root causes and servicing or repair may save the motor and may prevent sudden unexpected faults. Accordingly, the processing circuitry may be configured to generate an alert to an operator indicating a need for service or repair of the motor.

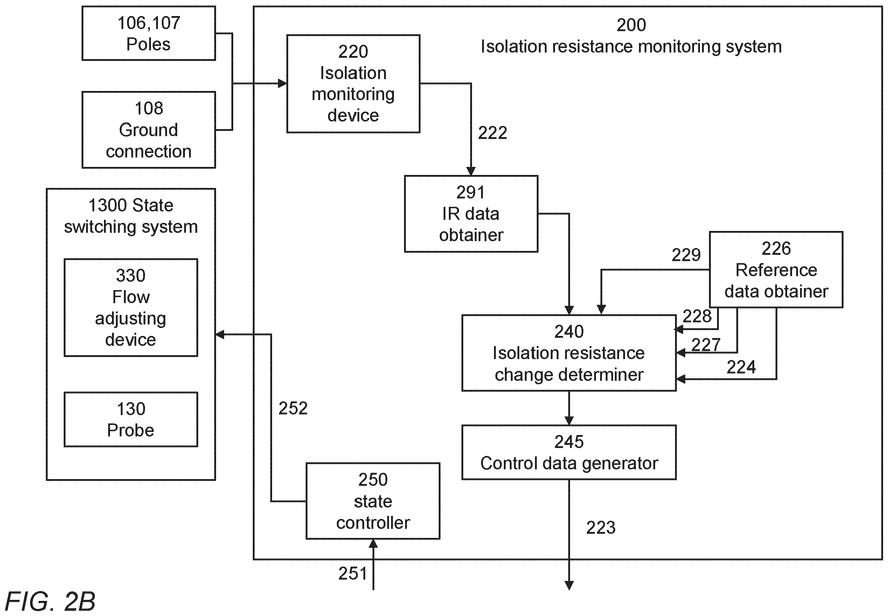

**FIG. 2B** shows a further example of a vehicle subsystem **10**.

The isolation resistance monitoring system **200** may comprise an isolation resistance data obtainer **291**. The isolation resistance data obtainer **291** may be configured to obtain the isolation resistance data **222**. In the depicted example, the isolation resistance data obtainer **291** may be configured to obtain the isolation resistance data **222**, e.g. the first and second isolation resistance data **222**, from the isolation monitoring device **220**.

The isolation resistance monitoring system **200** may comprise an isolation resistance change determiner **240**. Isolation resistance change determiner may be configured to determine the change in isolation resistance based on, e.g. between, the first and second isolation resistance data **222**.

The isolation resistance monitoring system **200** may comprise a control data generator **245**. The control data generator **245** may be configured to generate control data **223** for the vehicle 1 based on the determined change, e.g. the change determined by the isolation resistance change determiner **240**.

In one example, the processing circuitry **110**, e.g. the isolation resistance monitoring system **200**, may be configured to responsive to the determined change in isolation resistance being outside a fluid path isolation threshold, determine that the fluid path **320** leaks into the vehicle subsystem **10**.

In one example, the processing circuitry **110**, e.g. the isolation resistance monitoring system **200**, may be configured to responsive to the determined change in isolation resistance being outside a fluid path isolation threshold, determine that contamination has occurred in the vehicle subsystem **10**. Such a contamination may be in the form of an air or oil gap in the vehicle subsystem **10** being subjected to a contamination in the form of a fluid leaking into said air or oil gap. The fluid may cause the air or oil gap conducting.

For example, an air or oil cell of the vehicle subsystem **10** may be selectably energized against within a grounded enclosure. For example, considering an example where normally isolated coolant has leaked into the enclosure; when the air gap is tested for impact on isolation the higher-than-expected change may indicate a fault. This could be condensed water vapor or a flood or water leak from outside, or a coolant leak, or debris from a failing component.

The processing circuitry **110**, e.g. the isolation resistance monitoring system **200**, may be configured to obtain fluid path resistance data **229**. The fluid path resistance data **229** may be associated with the electrical resistance of the fluid path **320**. The processing circuitry **110**, e.g. the isolation resistance monitoring system **200**, may be configured to generate control data for the vehicle **1** based on the determined change in isolation resistance and the fluid path resistance data **229**. The fluid path resistance data **229** may be in the form of a pole resistance to ground in Ohm, such as a positive and negative pole resistance.

Typically, the resistance in parallel may be added or subtracted for obtaining a change affecting the total (between the first and second state). The total resistance may calculated as follows:

$$\frac{1}{R_{Total}} = \frac{1}{R_1} + \frac{1}{R_2};$$

wherein $R_{total}$ is the total resistance, e.g. measured total resistance, $R_1$ is the last total resistance, e.g. the total resistance associated with the first state and $R_2$ is the unknown resistance, e.g. the total resistance associated with the second state.

The isolation resistance monitoring system **200** may comprise a reference data obtainer **226**. The reference data obtainer **226** may be configured to obtain the fluid path resistance data **229**. The fluid path resistance data **229** may be provided as reference data, for example stored in storage device **120** of the computer system **100**. The fluid path resistance data **229** may be in the form of a resistance value associated with the fluid path. The value may be a calculated value obtained by a model of the fluid path **320** and/or a historic measured value of the resistance of the fluid path **320**. In one example, the reference data obtainer **226** may be configured to obtain the last total resistance, e.g. the total resistance associated with the first state.

The processing circuitry **110**, e.g. the isolation resistance monitoring system **200**, may be configured to responsive to the determined change in isolation resistance being outside a fault resistance threshold, determine that a fault is present in at least one of the vehicle subsystem **10** and the cooling system **300**.

The processing circuitry **110**, e.g. the isolation resistance monitoring system **200**, may be configured to responsive to the determined change in isolation resistance being outside a ground connection isolation resistance threshold, determine a faulty cooling system ground connection of the cooling system.

The reference data obtainer **226** may be configured to obtain the ground connection isolation resistance threshold **228.** The ground connection isolation resistance threshold **228** may be provided as an interval or upper or lower threshold indicative of a faulty cooling system ground connection. The ground connection isolation resistance threshold **228** may be provided as reference data, for example stored in storage device **120** of the computer system **100.**

The processing circuitry **110,** e.g. the isolation resistance monitoring system **200,** may be configured to obtain the fluid path resistance data based on geometrical characteristics of the fluid path **320** and/or characteristics of the coolant. The reference data obtainer **226** may be configured to obtain the fluid path resistance data **229** based on the geometrical characteristics **227** and/or the characteristics of the coolant **224.** The geometrical characteristics **227** and/or the characteristics of the coolant **224** may be provided as reference data, for example stored in storage device **120** of the computer system **100.**

The geometrical characteristics may comprise length data associated with the length **L** of the fluid path **320** and area data associated with the cross-section area **A** of the fluid path **320.** From the path geometry, e.g. the length and area, a path resistance σ may be calculated as follows:

$$\sigma = L/(R \cdot A);$$

However, as these values may be complex, the calculation of the conductivity may be simplified by utilizing a single constant or coefficient **C** relating the path resistance to conductivity. The single constant or coefficient may be calculated as follows:

$$C = \frac{L}{A}$$

The processing circuitry **110,** e.g. the isolation resistance monitoring system **200,** may be configured to obtain a diagnostic or fault tracing command **251.** In response to the diagnostic or fault tracing command **251,** the processing circuitry **110,** e.g. the isolation resistance monitoring system **200,** may be configured to cause a switch between the first and second state. The diagnostic or fault tracing command **251** may be obtained from the computer system **100** and/or a user interface operatively connected to the computer system **100.** Preferably, the processing circuitry **110** may be configured to cause operation in the first state and in response to the diagnostic or fault tracing command, cause a switch to the second state. Additionally or alternatively, the processing circuitry **110** may be configured to cause a switch between the first and the second state, e.g. from the first state to the second state, within set time intervals. Thereby, an automated check may be performed at regular intervals. The

Accordingly, operation in the first state may be considered a normal state which may be switched to the second state upon a check of the vehicle subsystem **10** or the cooling system **300** is to be performed.

The isolation resistance monitoring system **200** may comprise a state controller **250** configured to cause the switch between the first and second state. In the depicted example, the state controller **250** is configured to obtain the diagnostic or fault tracing command **251** and cause a switch between the first and second state in response to said diagnostic or fault tracing command **251.**

The vehicle **1,** e.g. the vehicle subsystem **10** may comprise a state switching system **1300.** The state switching system **1300** is configured to switch the state of the cooling path **320** between the first and second state. The isolation resistance monitoring system **200** and preferably the state controller **250** may be operatively connected to said state switching system **1300** and may be configured to control the state switching system **1300.** The state controller **250** may be configured to generate state control data **252** for the control the state switching system **1300.**

As will be described in further detail later on, the state switching system **1300** may be designed in a plurality of ways. The state switching system **1300** may comprise one or more components controllable to achieve the first and second state of the fluid path **320.**

In one example, the processing circuitry **110,** e.g. the isolation resistance monitoring system **200,** may be configured to cause a change between the first and the second state via a probe **130** exposed to the coolant.

In one example, the processing circuitry **110,** e.g. the isolation resistance monitoring system **200,** may be configured to energize the coolant in the fluid path **320** via the probe **130.** The probe **130** may be exposed to the coolant, e.g. the coolant in the fluid path **320,** to cause a change in energization between the first and second state. The state switching system **1300** may thus comprise the probe **130.**

In one example, the processing circuitry **110,** e.g. the isolation resistance monitoring system **200,** may be configured to control a flow adjusting device **330.** The flow adjusting device **330** may be arranged in the fluid path **320** to cause a change in the geometric characteristics of the coolant path **320** between the first and second state. The state switching system **1300** may thus comprise the flow adjusting device **330.**

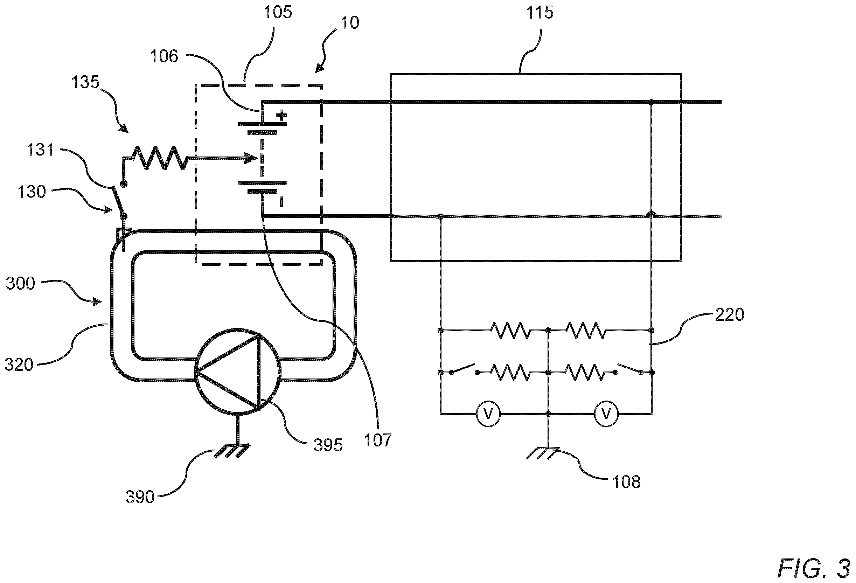

FIG. 3 illustrates a schematic representation of a vehicle subsystem **10,** incorporating the cooling system **300** designed to manage thermal conditions within the vehicle subsystem **10.** The cooling system comprises the fluid path **320,** through which coolant circulates, facilitated by the pump **395.** The fluid path **320** serves the function of maintaining desirable temperatures and enabling efficient operation of the vehicle subsystem **10.**

The vehicle **1,** e.g. the vehicle subsystem **10** may comprise the isolation monitoring device **220.** The isolation monitoring device **220** may operatively connected to the processing circuitry **110.** In one example, the isolation monitoring device **220** may be at least partly implemented by the processing circuitry **110.** The isolation monitoring device **220** may be configured to measure the isolation between the poles **106, 107** and the ground connection **108.** The isolation monitoring device **220** may be provide the first and second isolation resistance data. The isolation monitoring device **220** may thus serve to assess the electrical integrity of the subsystem.

In **FIG. 3,** the isolation monitoring device **220** measures the isolation resistance between the poles **106, 107** and the ground connection **108** through a system of bridges, switches, known resistances, and voltage sensors. Notably, the depicted isolation monitoring device **220** is for exemplary purposes only and may as the skilled person recognizes be implemented in a plurality of ways.

The isolation monitoring device **220** may operate by first establishing a baseline isolation resistance when the fluid path **320** is in its initial state. It may employ known resistances and strategically placed voltage sensors to accurately measure the voltage drop across these elements. By activating switches within the bridge circuit, the device can selectively connect or disconnect certain paths, enabling precise control and measurement of electrical parameters.

In **FIG. 3,** the isolation monitoring device **220** is implemented as an Isolation/Insulation Resistance Monitoring Device (IRM/IMD). The IRM/IMD may also integrate additional functionalities directly within the device, rather than relying on external components. Thus, the change in isolation resistance may be measured by the IRM/IMD in a manner that would otherwise require dedicated excitation and measurement circuitry to obtain.

It may be envisioned that the isolation monitoring device **220** may be configured to employ alternative methods for measuring the isolation resistance.

In the example of **FIG. 3,** the fluid path **320** of the cooling system **300** may be energized, whereby the isolation monitoring device **220** may be configured to measure a resulting potential change in isolation resistance between the poles **106, 107** and the ground connection **108.** In the example of **FIG. 3,** the power source **105** may normally be insulated from the coolant, whereby a connection may be created for the purpose of detecting the change in isolation resistance.

Accordingly, in the first state, the fluid path **320** may not be energized by means of the power source **105** while in the second state, the fluid path **320** may be energized by means of the power source **105.** As the coolant within the fluid path **320** transitions to an energized state, the isolation monitoring device **220** continues to measure the isolation resistance. This continuous monitoring capability may allow for the isolation monitoring device **220** to detect changes in isolation resistance, which could indicate potential faults or leaks. By providing real-time data to the processing circuitry **110,** e.g. the isolation resistance monitoring system **200,** the isolation monitoring device **220** may help to facilitate timely interventions, such as alert generation or system adjustments, thereby enhancing the safety and efficiency of the vehicle subsystem **10.**

In the example of **FIG. 3,** the energization may be achieved by means of a probe **130.** The probe **130** may be operatively connected to the processing circuitry **110,** e.g. the isolation resistance monitoring system **200,** for selective energization. Probe may herein refer to an electrode, e.g. an electrode for receiving an electric current and energizing the coolant.

The vehicle **1,** e.g. the vehicle subsystem **1,** may comprise a switch **131** selectively connecting the probe **130** to a potential of the vehicle subsystem **10.** Advantageously, the potential may be provided in the form of the poles **106, 107.** The processing circuitry **110,** e.g. the isolation resistance monitoring system **200,** may be operatively connected to the switch **131** to control the switch **131** to selectively energize the probe **130** to thereby energize the coolant.

The probe **130** may be positioned to interact with the coolant within the fluid path **320.** The probe **130** may thus be arranged to be exposed to the coolant within the fluid path **320.** The probe **130** may be configured to energize the coolant, inducing a change between the first and second state. The energization process allows for a dynamic assessment of the system's electrical isolation properties, providing data for system monitoring.

Within the context of the present disclosure, the probe **130** may be configured to energize the coolant within the fluid path **320** to enable monitoring of electrical isolation in the vehicle subsystem **10.** Various types of probes can be employed for this purpose.

A conductive probe can directly introduce an electrical charge into the coolant, allowing the system to assess changes in isolation resistance as the coolant becomes energized. This type of probe is effective for direct interaction with the fluid path, ensuring efficient distribution of electrical energy. An immersive electrode probe may also be suitable, designed to be submerged within the coolant to ensure uniform energization. This approach promotes consistent monitoring results by evenly distributing electrical energy throughout the fluid.

As aforementioned, the processing circuitry **110** may be operatively connected to the switch **131,** enabling precise control over the energization of the probe **130.** This setup enables that the coolant can be energized as needed, facilitating a responsive and adaptable monitoring system. The processing circuitry **110,** e.g. the isolation resistance monitoring system **200,** may be configured to control the switch **131** to cause switching between the first and second state of the fluid path **320.**

In one example, a set resistance **135** may be arranged between the probe 130 and the power source **105.** The set resistance **135** may thus be electrically connected to the probe **130** and the power source **105.** This configuration may allow for the current flowing through the probe **130** to remain within safe limits, preventing potential overloading or damage to the system components. The inclusion of the set resistance **135** may thus enhance the safety and reliability of the energization process.

In the depicted example, the isolation monitoring device **220** is electrically connected to a conductor **115,** e.g. a main DC-bus of the vehicle **1.** The conductor **115** may electrically connect the poles **106, 107** and the ground connection **108.**

In the depicted example, the conductor **115** serves as a main DC-bus within the vehicle **1.** The conductor **115** may be configured to function as an electrical pathway facilitating the distribution of power across various components of the vehicle's electrical system, for example between the power source **105** and other components of the vehicle **1.** By electrically connecting the poles **106, 107** and the ground connection **108,** the conductor **115** may enable efficient power transfer and stability within the system.

In the depicted example, the vehicle subsystem **10** is provided as a battery system or a fuel cell system. The power source **105** may thus be a battery cell system or a fuel cell stack. The conductor **115** may be configured to distribute power from the power source **105** to other components of the vehicle **1.**

As aforementioned the conductor **115** may be a main DC-bus. The main DC-bus may act as a centralized conduit for direct current, providing a stable and continuous flow of electricity to components of the vehicle **1.** This centralized setup allows for effective management and distribution of electrical power.

In one example, any of the isolation monitoring device **220,** the switch **130,** the set resistance **135** may be integrated in a power source thermal system configured to control the cooling system **300.** For example, the power source thermal system may be a battery thermal system or fuel cell thermal system.

As aforementioned, the isolation resistance monitoring system **200** may be configured to determine a faulty cooling system ground connection. In **FIG. 3,** a cooling system ground connection **390** is depicted. The isolation resistance monitoring system **200** may thus be configured to determine that the cooling system ground connection **390** is faulty based on the determined change in isolation resistance. The cooling system ground connection **390** may be a ground connection for one or more electrical component of the cooling system. In the depicted example, the cooling system ground connection **390** is electrically connected to the pump **395.**

In the example depicted in **FIG. 3,** the change in isolation resistance may indicate that the probe **130,** switch **131** or the set resistance **135** may be broken or that the connection to the cooling system ground connection **390** is broken in case a minimum expected change in isolation resistance is not observed.

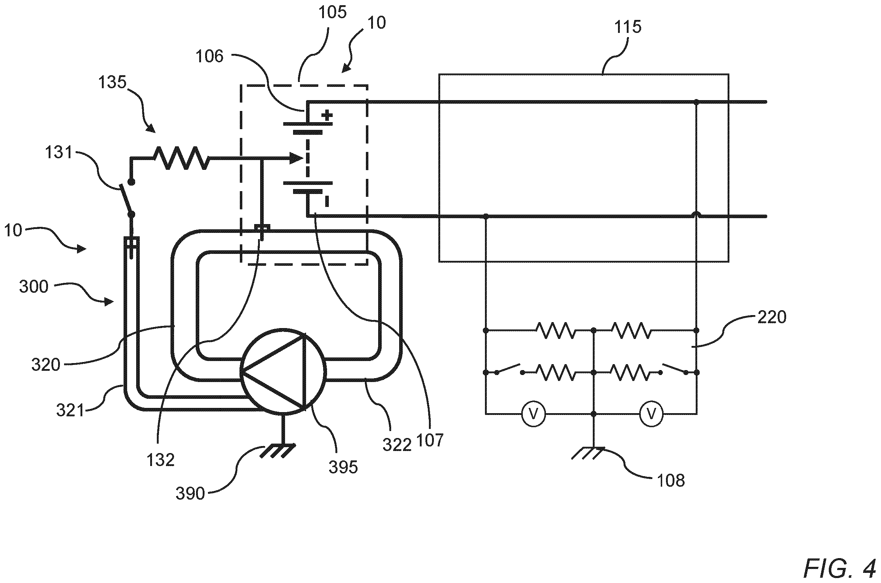

**FIG. 4** illustrates a schematic representation of a vehicle subsystem **10** according to another example. In the example of **FIG. 4,** the coolant may already be exposed to the power source **105.** Hence, the coolant is not isolated from the power source. In the depicted example, this is indicated by the electrical connection **132** between the fluid path **320** and the power source **105.** The second section **322** may thus be in electrical connection with the power source **105.** This may particularly be the case if the power source **105** is a fuel cell system or an immersion cooled battery system.

In the depicted example, the fluid path **320** comprises a first section **321** and a second section **322.**The first section **321** and the second section **322** may be parallel to each other. The first section **321** may be in electric connection with the switch **131** such that activation of the switch causes the first section **321** to be electrically connected to the set resistance **135.** The second section **322** may be electrically connected to the power source **105,** e.g. via the electric connection **132.** Hence, both the first state and the second state may be associated with the coolant in the fluid path **320** being energized.

Upon activation of the switch **131,** the set resistance electrically connects the power source **105** and the first section **321** to the poles **106, 107** and the ground connection **108** such that the first section **321** is energized. Accordingly, in the first state, only the second section **322** may be energized and in the second state, both the first and the second section **321, 322** may be energized. Thus, a change in isolation resistance may be achieved.

The activation of the switch **131** may be performed responsive to an instruction from the isolation resistance monitoring system **200** or continuously.

In the depicted example, the switch **131** may form a part of the power source thermal system, e.g. a part of an electric circuitry of the power source thermal system. It may further be envisioned that the electric connection **132** and the switch **131** also may form a part of the power source thermal system.

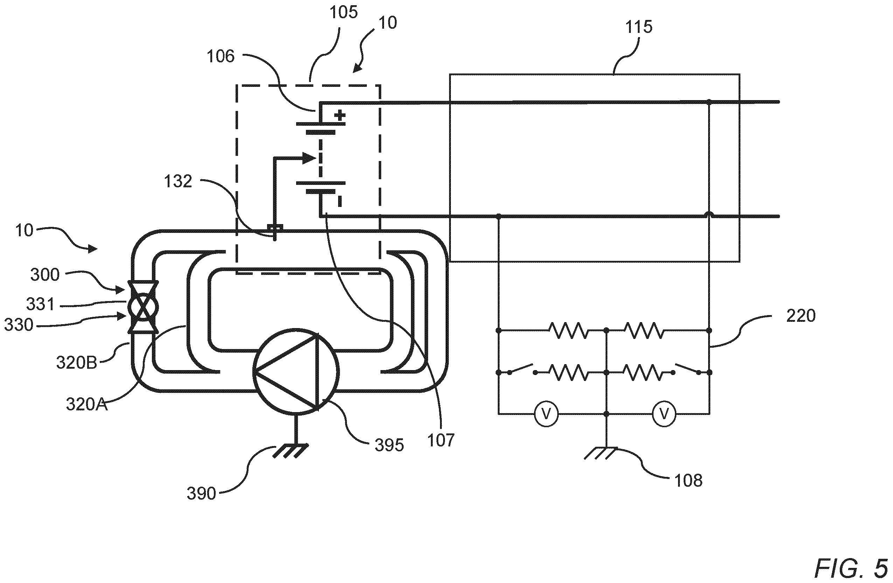

**FIG. 5** illustrates a schematic representation of a vehicle subsystem **10** according to another example. The example highlights a manner of determining the change in isolation resistance responsive to a change in current flow. In the depicted example, the first and second state of the fluid path **320** is associated with a first and second geometrical characteristic, respectively.

In the depicted example, the vehicle **1,** e.g. the vehicle subsystem **10,** may comprise a flow adjusting device **330.** The flow adjusting device **330** may be arranged in the fluid path **320** to cause a change in the geometric characteristics of the coolant path **320** between the first state and the second state.

In the example of **FIG. 5,** the coolant may already be exposed to the power source 105. Hence, the coolant is not isolated from the power source. In the depicted example, this is indicated by the electrical connection **132** between the fluid path **320** and the power source **105.**

Due to the coolant being energized, the flow adjusting device 330 may be configured to control the current flow through the fluid patch 320. For example, in the event of the flow adjusting device 330 sealing off a section of fluid path 320, the sealed off section may be removed from a baseline total resistance (associated with the first state) while the remaining section(s) of the fluid patch 320 remains part of that baseline total resistance (associated with the second state) which can be assumed constant over the change.

The processing circuitry 110, e.g. the isolation resistance monitoring system 200, may be configured to control the flow adjusting device 330 to cause a change in the geometric characteristics of the coolant path 320 between the first state and the second state.

The change in the geometric characteristics of the coolant path 320 and the resulting change in isolation resistance may be utilized to generate the previously described control data.

Referencing FIG. 5, the flow adjusting device 330 may be a component within the cooling system 300. The flow adjusting device 330 may be positioned in the fluid path 320 to facilitate a change in the geometric characteristics of the coolant path 320 thereby causing transitioning between a first and second state without the need to selectively energize the coolant. Various examples of flow adjusting devices may be considered to achieve this functionality.

In some examples, the flow adjusting device 330 may comprise a variable valve mechanism 331. The variable valve mechanism 331 may be configured to control the flow rate of the coolant within the fluid path 320. The processing circuitry 110, e.g. the isolation resistance monitoring system 200, may be configured to control the position of the variable valve mechanism 331 to change the geometric characteristics of the fluid path 320. By altering the position of the variable valve mechanism 331, e.g. the position of a valve member of the variable valve mechanism 331, the pathway of the coolant through the fluid path 320 is adjusted causing a change between the first and second state. Thereby, the geometric characteristics are changed, potentially impacting the isolation resistance measurements.

In some examples, the flow adjusting device 330 may comprise an adjustable baffle system arranged in the fluid path 320. These baffles can be repositioned or reoriented to modify the flow pattern and turbulence of the coolant, influencing the overall geometry of the path.

In some examples, the flow adjusting device 330 may comprise one or more multi-way valves configured to control the flow of coolant between flow paths. The flow paths may have different resistances and/or different lengths relative to the ground.

In some examples, the flow adjusting device 330 may comprise a flexible tubing system that can be expanded or contract by means of being engaged by an actuating system in response to control signals from the processing circuitry 110, e.g. the isolation resistance monitoring system 200. This flexibility allows for dynamic changes in the coolant path's shape and/or length, facilitating the monitoring of isolation resistance changes as the geometric characteristics vary.

To cause actuation of for example flexible tubing or the adjustable baffle system, the flow adjusting device 330 may comprise an actuator system such as an electromechanical actuator system. The actuator system may be configured to actuate the adjustable baffle system and/or the flexible tubing system to alter the flow path of the fluid path 320. This may enable targeted adjustments to the coolant path, enhancing the system's ability to detect changes in isolation resistance effectively.

In the depicted example, the fluid path 320 comprises two parallel and interconnected fluid path sections 320A-B. A first fluid path section 320A may be in fluid communication with a second fluid path section 320B and may be arranged in parallel to said second fluid path section 320B. The flow adjusting device 330 may be arranged in the second fluid path section 320B and be configured to control the flow in said second fluid path section 320B to cause the fluid path 320 to switch between operating in the first state and the second state.

The second fluid path section 320B may be selectively sealed off by means of the flow adjusting device 330. In the first state, the flow adjusting device 330 may be configured to seal off the second fluid path section 320B. In the second state, the flow adjusting device 330 may be configured to enable flow through the second fluid path section 320B, thereby altering the geometric characteristics of the fluid path 320.

In the depicted example, the coolant may be energized. In the first state, the coolant will only flow through the first fluid path section 320A due to flow adjusting device 330 blocking passage into the second fluid path section 320B, resulting in a first determined isolation resistance between the poles 106, 107 and the ground connection 108. The processing circuitry 110, e.g. the isolation resistance monitoring system 200, may then cause the switch from the first state to the second state by controlling the flow adjusting device 330 to enable passage of coolant into the second fluid path section 320B. This results in a second determined isolation resistance between the poles 106, 107 and the ground connection 108.

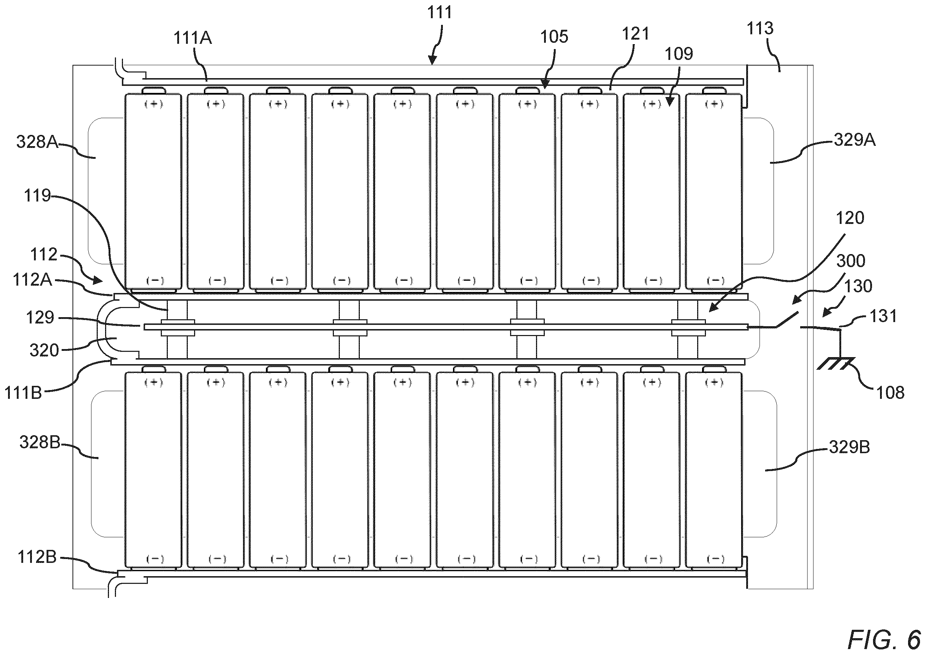

FIG. 6 depicts a vehicle subsystem 10 according to another example. In the depicted example, the vehicle subsystem 10 is formed by a battery system and in particular an immersion cooled battery system. Accordingly, the battery system 10 may comprise one or more immersion cooled batteries 109. Further, the cooling system 300 may be provided as an immersion cooling system.

The depicted example highlights an approach to thermal management, where one or more immersion cooled batteries 109 are integrated into the cooling system 300, provided as an immersion cooling system.

Within this system, the fluid path 320 may be configured to circulate coolant in the form a dielectric fluid around the immersion cooled batteries **109**. The one or more immersion cooled batteries **109** may thus be arranged in the fluid path **320**. The fluid path **320** may serve to remove or supply heat to or from the immersion cooled batteries **109** for maintaining desirable operating temperatures and enhancing the performance and longevity of the battery system. As the coolant circulates through the fluid path **320,** the coolant absorbs heat from the immersion cooled batteries **109** and carries it away from critical components. By directly surrounding the immersion cooled batteries **109** with the coolant within the fluid path **320,** the system may reduce the occurrences of hotspots and improve thermal management. This approach may be particularly advantageous in high-performance applications, supporting the reliable operation and safety of the vehicle subsystem **10**.

Further referencing **FIG. 6,** the vehicle **1,** e.g. the vehicle subsystem **10** herein provided as a battery system, comprises a shielding **113,** a conductor **115** or a collector plate **129**. The shielding **113,** the conductor **115** or collector plate **129** may form the probe **130**. The shielding, the conductor or collector plate may be arranged adjacent to an area of similar voltage potential within the immersion cooled batteries **109**. A shielding, conductor or collector plate commonly forms a part of a battery system and in particular an immersion cooled battery system. Thus, this may allow for monitoring of the isolation resistance in a manner not requiring a surplus of additional components. In the depicted example, the conductor may be provided in the form of a busbar.

In the depicted example, the vehicle **1,** e.g. the vehicle subsystem **10,** comprises an additional conductor or collector plate **129** functioning as a probe **130** as previously described. The conductor or collector plate **129** may be provided in addition to a cathode collector plate **111** and an anode collector plate **112** electrically connected to the poles of the one or more immersion cooled batteries **109**. The conductor or collector plate **129** may be arranged such that it has substantially the same or at least similar potential compared to the anode collector plate **112** and the cathode collector plate **111**. The conductor or collector plate **129** may thus normally float with the same potential as the adjacent anode/-cathode collector plates **111, 112** but presents an isolation fault proportional to the constant geometry and variable conductivity when bonded to the ground connection **108**. In the depicted example, the conductor or collector plate **129** is arranged proximal to the anode collector plate **112**.

To exemplify, at the cell level, exposure may be to a number of similar potentials to generate a significant area from a plurality of small areas or alternatively it may be a large area provided at one potential level. At the pack/stack level this could for example be at a mid-potential in which case if at one single level then the cathode potential of one stack or module of cells is the anode level of the next stack or module of cells.

Further referencing **FIG. 6,** the conductor or collector plate **129** may be separated from the anode collector plate **112** or cathode collector plate **111** by means of one or more insulating spacers **119**. It may be envisioned that one or more insulating spacers **119** comprises one or more spacer elements arranged between the conductor or collector plate **129** and the anode collector plate **112** or the cathode collector plate **111**. In another example, the one or more insulating spacers **119** may comprise an insulating and perforated plate. Notably, any type of conventional insulating spacers **119** may be utilized provided that said insulating spacer **119** provides exposure to the coolant in the fluid path **320** for the conductor or collector plate **129**.

In the depicted example, the conductor or collector plate **129** is selectively connectable to the ground connection **108** by means of the switch **131**. Hence, the switch **131** may be configured to cause the fluid path **320** to switch between operating in the first and the second state by means of connecting and disconnecting the conductor or collector plate **129** to and from the ground connection **108**. In one example the switch **131** may be provided as a contactor. In one example, the switch **131** may comprise a relay for feed-though for bonding to the ground connection **108**. In one example, the switch **131** may comprise an internal armature driven by an electromagnet or hermitic solenoid or similar. This may allow for a switch **131** which is highly localized and/or galvanically isolated which may improve life and safety should it need to be serviced.

The ground connection **108** may in one example be bonded to the chassis of the vehicle **1**. The ground connection **108** may for example be welded to the chassis. In one example, the ground connection **108** may be bonded to the chassis or enclosure of the power source **105,** e.g. the battery system or fuel cell system.

Referencing **FIG. 6,** the battery system may comprise a plurality of modules each comprising one or more immersion cooled battery **109**. In one example, a conductor or collector plate **129** functioning as a probe **130** may be inserted at a substantially middle potential location in the series of (parallel cell) modules making up the battery pack of the battery system so as to generate a symmetric isolation fault. Alternatively, the conductor or collector plate **129** may be arranged to be offset towards or located at one of the poles to get an intentionally asymmetric fault. The system with the switch **131** and the conductor or collector plate **129** may be considered a measuring cell. For example, two or more measuring cells may be utilized to get more information and also to have the possibility to select fault size by varying the number of faults used simultaneously.

In the depicted example, the conductor or collector plate **129** is arranged at a substantially middle potential location, e.g. between the anode collector plate **112A** of a first battery module and a cathode collector plate **111B** of a second battery module. Isolation spacers **119** are arranged to separate the conductor or collector plate **129** from said anode collector plate **112A** and cathode collector plate **111B**.

In the depicted example, the fluid path **320** may comprise an inlet **328** and outlet **329**. Advantageously, the fluid path **320** may comprise an inlet and outlet for each battery module for distributing coolant for immersing the one or more immersion cooled batteries **109** of said battery module. Accordingly, the fluid path **320** may comprise a first inlet **328A** configured to receive coolant for immersing the one or more immersion cooled batteries of the first battery module and a first outlet **329A** for guiding the coolant away from the fluid path **302** and the first battery module. Similarly, the fluid path **320** may comprise a second inlet **328B** configured to receive coolant for immersing the one or more immersion cooled batteries of the second battery module and a second outlet **329B** for guiding the coolant away from the fluid path **302** and the second battery module.

As depicted in **FIG. 6,** the battery system, e.g. the immersion cooled battery system, may comprise the shielding **113**. The shielding **113** may be in an insulating material and may be configured to encapsulate the battery system. The one or more inlet **328** and one or more outlet **329** may extend through the shielding **113**.

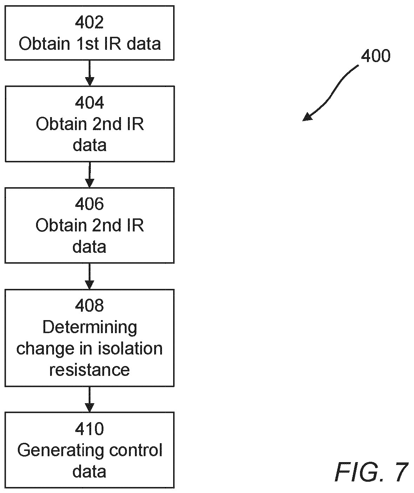

**FIG. 7** is a flow chart of a method **400** for determining a change in isolation resistance according to an example. The method **400** may be a computer-implemented method.

The method **400** comprises obtaining **402,** by processing circuitry of a computer system, first isolation resistance data associated with an isolation resistance between poles **106, 107** of vehicle subsystem **10** of a vehicle **1** and a ground connection **108,** wherein a fluid path **320** of a cooling system **300** configured to cool the vehicle subsystem **10** is in a first state.

The method **400** further comprises obtaining **404,** by the processing circuitry, second isolation resistance data associated with an isolation resistance between the poles **106, 107** and the ground connection **108** wherein the fluid path **320** is in a second state, wherein coolant in the fluid path **320** is electrically energized in at least the second state.

The method **400** further comprises determining **408,** by the processing circuitry, a change in isolation resistance between the poles **106, 107** and the ground connection **108** based on the first and second isolation resistance data.

The method **400** further comprises generating **410,** by the processing circuitry, control data for the vehicle **1** based on the determined change.

Optionally, the method **400** may comprise obtaining, by the processing circuitry, fluid path resistance data associated with the electrical resistance of the fluid path **320** and generating **410,** by the processing circuitry, control data based for the vehicle **1** based on the determined change in isolation resistance and the fluid path resistance data.

Optionally, the method **400** may comprise responsive to the determined change in isolation resistance being outside a coolant isolation resistance threshold, determining, by the processing circuitry, that the fluid path **320** leaks into the vehicle subsystem **10**.

**FIG. 8** is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806**. The computer system **800** may include at least one computing device having the processing circuitry **802**. The system bus **806** provides an interface for system components including, but not limited to, the memory **804** and the processing circuitry **802**. The processing circuitry **802** may include any number of hardware components for conducting data or signal processing or for executing computer code stored in memory **804**. The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-maccess memory (RAM)), or any other medium which can be used to carry or store desired program code in the form of machine-executable instructions or data structures and which can be accessed by a computer or other machine with processing circuitry **802**. A basic input/output system (BIOS) **812** may be stored in the non-volatile memory **808** and can include the basic routines that help to transfer information between elements within the computer system **800**.

The computer system **800** may further include or be coupled to a non-transitory computer-readable storage medium such as the storage device **814**, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818**. All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device

interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

According to an aspect, a computer system, vehicle, method, computer program product and non-transitory computer-readable storage medium according to any of the following examples provided.

Example 1: Computer system comprising processing circuitry configured to: obtain first isolation resistance data associated with an isolation resistance between poles (106, 107) of a vehicle subsystem (10) of a vehicle (1) and a ground connection (108) wherein a fluid path (320) of a cooling system (300) configured to cool the vehicle subsystem (10) is in a first state, obtain second isolation resistance data associated with an isolation resistance between the poles (106, 107) and the ground connection (108) wherein the fluid path (320) is in a second state, wherein coolant in the fluid path (320) is electrically energized at least in the second state, and determine a change in isolation resistance between the poles (106, 107) and the ground connection (108) based on the first and second isolation resistance data, and generate control data for the vehicle (1) based on the determined change.

Example 2: Computer system of example 1, wherein the processing circuitry is further configured to: obtain fluid path resistance data associated with the electrical resistance of the fluid path (320), and generate control data for the vehicle (1) based on the determined change in isolation resistance and the fluid path resistance data.

Example 3: Computer system of any of examples 1-2, wherein the processing circuitry is further configured to: responsive to the determined change in isolation resistance being outside a fluid path isolation resistance threshold, determine that the fluid path (320) leaks into the vehicle subsystem (10).

Example 4: Computer system of any of examples 1-3, wherein the processing circuitry is further configured to: responsive to the determined change in isolation resistance being outside a fault resistance threshold, determine that a fault is present in at least one of the vehicle subsystem (10) and the cooling system (300).

Example 5: Computer system of any of examples 2-4, wherein the processing circuitry is further configured to: obtain the fluid path resistance data based on geometrical characteristics of the fluid path (320) and/or characteristics of the coolant.

Example 6: Computer system of any of examples 1-5, wherein the processing circuitry is further configured to: obtain a diagnostic or fault tracing command, and responsive to the diagnostic or fault tracing command cause a switch between the first and second state.

Example 7: Computer system of any of examples 1-6, wherein the processing circuitry is further configured to: cause a change between the first and the second state via a probe (130) exposed to the coolant.

Example 8: Computer system of any of examples 1-7, wherein the processing circuitry is further configured to: control a flow adjusting device (330) arranged in the fluid path (320) to cause a change in the geometric characteristics of the coolant path (320) between the first state and the second state.

Example 9: A vehicle (1) comprising the computer system of any of examples 1-8.

Example 10: The vehicle (1) of example 9, further comprising an isolation monitoring device (220) operatively connected to the processing circuitry and configured to measure the isolation between the poles (106, 107) and the ground connection (108) to provide the first and second isolation resistance data.

Example 11: The vehicle (1) of example 9 or 10, further comprising a switch (131) selectively connecting a probe (130) to a potential of the vehicle subsystem (10), such as the poles (106, 107), wherein the processing circuitry is operatively connected to the switch (131) to control said switch (131) to selectively energize the probe (130) to thereby energize the coolant.

Example 12: The vehicle (1) of any of examples 9-11, further comprising a set resistance (135) arranged between the probe (130) and a power source (105) for energizing the probe (130).

Example 13: The vehicle (1) of any of examples 9-12, further comprising at least one fuel cell system forming the vehicle subsystem.

Example 14: The vehicle (1) of any of examples 9-12, further comprising at least one battery system forming the vehicle subsystem.

Example 15: The vehicle (1) of example 14, wherein the battery system comprises one or more immersion cooled batteries (109) and the cooling system (300) is provided as an immersion cooling system.

Example 16: The vehicle (1) of example 15, further comprising a shielding, conductor (115) or collector plate (129), wherein said shielding, conductor or collector plate (129) forms the probe (130) and is arranged adjacent to an area of similar voltage potential of the one or more immersion cooled batteries (109).

Example 17: The vehicle (1) of any of examples 9-12, further comprising at least one motor drive system forming the vehicle subsystem.

Example 18: The vehicle (1) of example 9, further comprising at least one battery system and/or fuel cell system forming the vehicle subsystem, wherein the processing circuitry is further configured to: energizing the coolant in the fluid path (320) via a probe (130) exposed to the coolant to cause a change in energization between the first state and the second state, obtain fluid path resistance data associated with the electrical resistance of the fluid path (320), generate control data for the vehicle (1) based on the determined change in isolation resistance and the fluid path resistance data, and responsive to the determined change in isolation resistance being outside a fluid path isolation resistance threshold, determine that the fluid path (320) leaks into the vehicle subsystem (10).

Example 19: A computer-implemented method comprising: obtaining, by processing circuitry of a computer system, first isolation resistance data associated with an isolation resistance between poles (106, 107) of a vehicle subsystem (10) of a vehicle (1) and a ground connection (108), wherein a fluid path (320) of a cooling system (300) configured to cool the vehicle subsystem (10) is in a first state, obtaining, by the processing circuitry, second isolation resistance data associated with an isolation resistance between the poles (106, 107) and the ground connection (108) wherein the fluid path (320) is in a second state, wherein coolant in the fluid path (320) is electrically energized in at least the second state,

determining, by the processing circuitry, a change in isolation resistance between the poles (106, 107) and the ground connection (108) based on the first and second isolation resistance data, and generating, by the processing circuitry, control data for the vehicle (1) based on the determined change.

Example 20: Computer-implemented method of example 19, further comprising: obtaining, by the processing circuitry, fluid path resistance data associated with the electrical resistance of the fluid path (320), and generating, by the processing circuitry, control data for the vehicle (1) based on the determined change in isolation resistance and the fluid path resistance data.

Example 21: Computer-implemented method of example 20, further comprising: responsive to the determined change in isolation resistance being outside a coolant isolation resistance threshold, determine, by the processing circuitry, that the fluid path (320) leaks into the vehicle subsystem (10).

Example 22: A computer program product comprising program code for performing, when executed by the processing circuitry, the method of any of examples 19-21.

Example 23: A non-transitory computer-readable storage medium comprising instructions, which when executed by the processing circuitry, cause the processing circuitry to perform the method of any of examples 19-21.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1. Computer system comprising processing circuitry configured to:

    obtain first isolation resistance data associated with an isolation resistance between poles (106, 107) of a vehicle subsystem (10) of a vehicle (1) and a ground connection (108) wherein a fluid path (320) of a cooling system (300) configured to cool the vehicle subsystem (10) is in a first state,
    obtain second isolation resistance data associated with an isolation resistance between the poles (106, 107) and the ground connection (108) wherein the fluid path (320) is in a second state, wherein coolant in the fluid path (320) is electrically energized at least in the second state, and
    determine a change in isolation resistance between the poles (106, 107) and the ground connection (108) based on the first and second isolation resistance data, and generate control data for the vehicle (1) based on the determined change.

2. Computer system of claim 1, wherein the processing circuitry is further configured to:

    obtain fluid path resistance data associated with the electrical resistance of the fluid path (320), and

generate control data for the vehicle (1) based on the determined change in isolation resistance and the fluid path resistance data.

3. Computer system of any of claim 1-2, wherein the processing circuitry is further configured to:
responsive to the determined change in isolation resistance being outside a fluid path isolation resistance threshold, determine at least one of that the fluid path (320) leaks into the vehicle subsystem (10) and that contamination has occurred in the vehicle subsystem (10).

4. Computer system of any of claim 1-3, wherein the processing circuitry is further configured to:
responsive to the determined change in isolation resistance being outside a fault resistance threshold, determine that a fault is present in at least one of the vehicle subsystem (10) and the cooling system (300).

5. Computer system of any of claim 2-4, wherein the processing circuitry is further configured to:
obtain the fluid path resistance data based on geometrical characteristics of the fluid path (320) and/or characteristics of the coolant.

6. Computer system of any of claim 1-5, wherein the processing circuitry is further configured to:
cause a change between the first and the second state via a probe (130) exposed to the coolant.

7. Computer system of any of claim 1-6, wherein the processing circuitry is further configured to:
control a flow adjusting device (330) arranged in the fluid path (320) to cause a change in the geometric characteristics of the coolant path (320) between the first state and the second state.

8. A vehicle (1) comprising the computer system of any of claims 1-7.

9. The vehicle (1) of claim 8, further comprising an isolation monitoring device (220) operatively connected to the processing circuitry and configured to measure the isolation between the poles (106, 107) and the ground connection (108) to provide the first and second isolation resistance data.

10. The vehicle (1) of claim 9 or 10, further comprising a switch (131) selectively connecting a probe (130) to a potential of the vehicle subsystem (10), such as the poles (106, 107), wherein the processing circuitry is operatively connected to the switch (131) to control said switch (131) to selectively energize the probe (130) to thereby energize the coolant.

11. The vehicle (1) of any of claim 8-10, further comprising at least one battery system forming the vehicle subsystem, wherein the battery system comprises one or more immersion cooled batteries (109) and the cooling system (300) is provided as an immersion cooling system, the vehicle (1) further comprising a shielding, conductor (115) or collector plate (129), wherein said shielding, conductor or collector plate (129) forms the probe (130) and is arranged adjacent to an area of similar voltage potential of the one or more immersion cooled batteries (109).

12. The vehicle (1) of claim 8, further comprising at least one battery system and/or fuel cell system forming the vehicle subsystem, wherein the processing circuitry is further configured to:

energizing the coolant in the fluid path (320) via a probe (130) exposed to the coolant to cause a change in energization between the first state and the second state,
obtain fluid path resistance data associated with the electrical resistance of the fluid path (320),
generate control data for the vehicle (1) based on the determined change in isolation resistance and the fluid path resistance data, and
responsive to the determined change in isolation resistance being outside a fluid path isolation resistance threshold, determine that the fluid path (320) leaks into the vehicle subsystem (10).

13. A computer-implemented method comprising:

obtaining, by processing circuitry of a computer system, first isolation resistance data associated with an isolation resistance between poles (106, 107) of a vehicle subsystem (10) of a vehicle (1) and a ground connection (108), wherein a fluid path (320) of a cooling system (300) configured to cool the vehicle subsystem (10) is in a first state,
obtaining, by the processing circuitry, second isolation resistance data associated with an isolation resistance between the poles (106, 107) and the ground connection (108) wherein the fluid path (320) is in a second state, wherein coolant in the fluid path (320) is electrically energized in at least the second state,
determining, by the processing circuitry, a change in isolation resistance between the poles (106, 107) and the ground connection (108) based on the first and second isolation resistance data, and
generating, by the processing circuitry, control data for the vehicle (1) based on the determined change.

**14.** A computer program product comprising program code for performing, when executed by the processing circuitry, the method of claim 13.

**15.** A non-transitory computer-readable storage medium comprising instructions, which when executed by the processing circuitry, cause the processing circuitry to perform the method of claim 13.

FIG. 1

*FIG. 2A*

FIG. 2B

FIG. 3

EP 4 759 609 A1

FIG. 4

FIG. 5

EP 4 759 609 A1

FIG. 6

```
┌─────────────────┐
│      402        │
│ Obtain 1st IR data │
└─────────────────┘
         │
         ▼
┌─────────────────┐
│      404        │
│  Obtain 2nd IR  │
│      data       │
└─────────────────┘
         │
         ▼
┌─────────────────┐
│      406        │
│  Obtain 2nd IR  │
│      data       │
└─────────────────┘
         │
         ▼
┌─────────────────┐
│      408        │
│   Determining   │
│change in isolation│
│    resistance   │
└─────────────────┘
         │
         ▼
┌─────────────────┐
│      410        │
│Generating control│
│      data       │
└─────────────────┘
```

400

*FIG. 7*

*FIG. 8*

EP 4 759 609 A1

Europäisches
Patentamt

European
Patent Office

Office européen
des brevets

**EUROPEAN SEARCH REPORT**

Application Number

EP 24 22 0199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 9 634 362 B2 (SAMSUNG SDI CO LTD [KR]) 25 April 2017 (2017-04-25) * column 5, line 65 - column 6, line 10 * * column 9, line 26 - line 64 * * column 5, line 33 - line 49 * ----- | 1-15 | INV. B60L3/00 B60L58/26 B60L3/04 |
| Y | DE 10 2016 212275 A1 (BAYERISCHE MOTOREN WERKE AG [DE]) 11 January 2018 (2018-01-11) * paragraph [0034] * * paragraph [0041] * * paragraph [0044] * * figure 3 * ----- | 1-15 | |
| A | CN 113 036 237 A (PEUGEOT CITROEN AUTOMOBILES SA) 25 June 2021 (2021-06-25) * the whole document * ----- | 1-15 | |

TECHNICAL FIELDS
SEARCHED        (IPC)

B60L

The present search report has been drawn up for all claims

| Place of search | Date of completion of the search | Examiner |
|---|---|---|
| The Hague | 13 June 2025 | Marín Saldaña, I |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

&  : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 22 0199

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2025

| Patent document cited in search report | | Publication date | Patent family member(s) | | Publication date |
|---|---|---|---|---|---|
| US 9634362 | B2 | 25-04-2017 | CN | 103847505 A | 11-06-2014 |
| | | | EP | 2738033 A1 | 04-06-2014 |
| | | | US | 2014154537 A1 | 05-06-2014 |
| DE 102016212275 A1 | | 11-01-2018 | NONE | | |
| CN 113036237 | A | 25-06-2021 | NONE | | |

EPO FORM P0459

For more details about this annex : see Official Journal of the European Patent Office, No. 12/82